# EUROPEAN PATENT SPECIFICATION

(11) **EP 2 960 489 B1**
(45) Date of publication and mention of the grant of the patent: **23.11.2016**
(21) Application number: 15163085.2
(22) Date of filing: 10.04.2015
(51) Int. Cl.: F02P 19/02, H01H 37/76, H05K 1/02, H05K 1/18, H03K 17/082, H03K 17/18, H03K 17/687, H02H 3/08, H02H 5/04, H03K 17/08, H01H 37/04, H03K 17/0812

(54) **CONTROL APPARATUS**
STEUERUNGSVORRICHTUNG
APPAREIL DE CONTRÔLE

(30) Priority: 23.04.2014 JP 2014088940
(43) Date of publication of application: 30.12.2015
(73) Proprietor: NGK Spark Plug Co., Ltd., Nagoya-shi, Aichi 467-8525 (JP)
(72) Inventor: Kumazawa, Shinji, Nagoya, Aichi 467-8525 (JP); Toda, Satoru, Nagoya, Aichi 467-8525 (JP); Kawagishi, Wataru, Nagoya, Aichi 467-8525 (JP); Nakano, Hitoshi, Nagoya, Aichi 467-8525 (JP)
(74) Representative: Grünecker Patent- und Rechtsanwälte PartG mbB

(56) References cited:
- EP-A1- 1 811 819
- GB-A- 2 300 340
- US-A1- 2007 103 006
- US-B1- 6 445 277

## Description

### [Technical Field]

The present invention relates to a control apparatus in which an IC package or the like including a semiconductor switch is disposed on a printed circuit board.

### [Background Art]

Patent Document 1 discloses a control apparatus which includes a transistor switch for driving a heater element of an automobile such as a glow plug, and a control circuit for controlling the transistor switch. In this control apparatus, an overheat protection element whose contact connection is cancelled when its temperature exceeds a limiting temperature is provided on at least one of the high side (high voltage side) and the low side (low voltage side) of the transistor switch. The overheat protection element is configured such that the electrical connection between conductor members is formed by means of soldering, and a mechanical stress (e.g., spring force) is applied to the electrically connected portion. When the temperature exceeds the limiting temperature, the solder melts and the electrical connection is broken by the spring force.

According to the technique of Patent Document 1, when the temperature of the control apparatus becomes high as a result of occurrence of a failure in the transistor switch or the control circuit therefor, the electrical connection in the overheat protection element is broken, whereby overheating of the control apparatus can be prevented.

### [Prior Art Document]

### [Patent Document]

[Patent Document 1] Japanese Kohyo (PCT) Patent Publication No. 2008-530727

### [Summary of the Invention]

### [Problems to be Solved by the Invention]

However, the above-described conventional technique has a problem in that, when a plurality of transistor switches are present, the overheat protection element must be provided for each of the transistor switches, and the configuration of the entire control apparatus becomes complex. Also, the conventional technique has a problem in that, if an attempt is made to dispose a plurality of transistor switches and a plurality of overheat protection elements on the same board, the area of the board increases.

### [Means for Solving the Problems]

The present invention has been accomplished so as to solve the above-described problems, and the present invention can be realized as the following modes.
(1) According one mode of the present invention, there is provided a control apparatus in which a switch IC is disposed on a printed circuit board, the switch IC being an IC package including a semiconductor switch and being provided on a high-voltage side of a resistive load so as to drive the resistive load. In this control apparatus, a plurality of the switch ICs are disposed on the printed circuit board, and an overheat prevention component is provided and is in common connection with the plurality of switch ICs. The overheat prevention component includes a passive element having a function of interrupting or limiting current flowing through the plurality of switch ICs in response to temperature rise. The plurality of switch ICs are disposed such that no switch IC is present between any of the switch ICs and the overheat prevention component.
   According to this configuration, irrespective of which one of the switch IC breaks, overheating of the broken switch IC can be prevented to the same degree by the overheat prevention component. Also, sine the single overheat prevention component provides overheat protection for the plurality of switch ICs, the configuration of the entire control apparatus can be simplified, and an excessive increase in the area of the printed circuit board can be prevented.
(2) In the above-described control apparatus, when the plurality of switch ICs and the overheat prevention component are projected in a thickness direction of the printed circuit board, the plurality of switch ICs may be disposed such that the center of each switch IC is present within a circle whose center coincides with the center of the overheat prevention component and whose radius is (0.5·L1 + 1.5·L2), where L1 is the dimension of the overheat prevention component in the longitudinal direction thereof, and L2 is the dimension of each switch IC in the longitudinal direction thereof.
   According to this configuration, the distance between each switch IC and the overheat prevention component is limited to a short range. Therefore, overheating of each switch IC can be prevented more reliably.
(3) In the above-described control apparatus, when the plurality of switch ICs and the overheat prevention component are projected in the thickness direction of the printed circuit board, the plurality of switch ICs may be disposed such that the shortest distance between the perimeter of each switch IC and the perimeter of the overheat prevention component is smaller than the dimension of each switch IC in the longitudinal direction thereof.
   According to this configuration, the distance between each switch IC and the overheat prevention component is limited to a shorter range. Therefore, overheating of each switch IC can be prevented with further reliability.
(4) In the above-described control apparatus, when the plurality of switch ICs and the overheat prevention component are projected in the thickness direction of the printed circuit board, the plurality of switch ICs may be disposed such that an inter-center distance which is the distance between the center of any of the switch ICs and the center of the overheat prevention component falls within a range of ±30% of the average of the inter-center distances regarding the plurality of switch ICs.
   According to this configuration, overheating of each switch IC can be prevented to the same degree.
(5) In the above-described control apparatus, when the plurality of switch ICs and the overheat prevention component are projected in the thickness direction of the printed circuit board, the plurality of switch ICs may be disposed such that the centers of the plurality of switch ICs are disposed at positions which are spaced from the center of the overheat prevention component by the same amount.
   According to this configuration, overheating of each switch IC can be prevented to the same degree.
(6) In the above-described control apparatus, when the plurality of switch ICs and the overheat prevention component are projected in the thickness direction of the printed circuit board, the plurality of switch ICs may be disposed at positions which are in rotational symmetry or line symmetry with respect to the overheat prevention component.
   According to this configuration, the positional relation with respect to the overheat prevention component can be rendered uniform among the plurality of switch ICs. Therefore, the overheat protection effect can be made uniform among the plurality of switch ICs.
(7) In the above-described control apparatus, the plurality of switch ICs and the overheat prevention component may be disposed on a first surface of the printed circuit board; and the overheat prevention component may be disposed at a position between the plurality of switch ICs.
   According to this configuration, overheating of each switch IC can be prevented to approximately the same degree through use of the overheat prevention component present at a position between the plurality of switch ICs.
(8) In the above-described control apparatus, when the plurality of switch ICs and the overheat prevention component are projected in the thickness direction of the printed circuit board, the plurality of switch ICs and the overheat prevention component may be disposed in a positional relation such that the contour of the overheat prevention component and the contour of each switch IC partially overlap with each other.
   According to this configuration, the distance between each switch IC and the overheat prevention component can be shortened. Therefore, overheating of each switch IC can be prevented more effectively.
(9) In the above-described control apparatus, the plurality of switch ICs may be disposed on a first surface of the printed circuit board; and the overheat prevention component may be disposed on a second surface of the printed circuit board.
   According to this configuration, the degree of freedom of layout increases, and the area of the printed circuit board can be decreased.
(10) In the above-described control apparatus, the passive element may be a thermal fuse having an interrupting current of 200 A or greater.

According to this configuration, it is possible to realize overheat protection for the switch IC while allowing large current to flow through the resistive load.

Notably, the present invention can be realized in various forms. For example, the present invention can be realized as a control apparatus, a method for manufacturing a control apparatus, or a method for disposing electronic components.

### [Brief Description of the Drawings]

[FIG. 1] Plan view of a control apparatus which is one embodiment.
[FIG. 2] Block diagram showing the circuit configuration of the control apparatus.
[FIG. 3] Explanatory graph showing an example of change in the temperature of a switch IC.
[FIG. 4] Block diagram showing another circuit configuration of the control apparatus.
[FIG. 5] Explanatory view showing an example of a preferred layout condition of switch ICs and a thermal fuse.
[FIG. 6(A)] Explanatory view showing an example in which two switch ICs are disposed at positions which are in line symmetry and rotational symmetry with respect to a single thermal fuse.
[FIG. 6(B)] Explanatory view showing an example in which two switch ICs are disposed at positions which are in line symmetry with respect to a single thermal fuse.
[FIG. 7(A)] Explanatory view showing an example in which three switch ICs are disposed at positions which are in line symmetry and rotational symmetry with respect to a single thermal fuse.
[FIG. 7(B)] Explanatory view showing an example in which three switch ICs are disposed at positions which are in line symmetry with respect to a single thermal fuse.
[FIG. 8(A)] Explanatory view showing an example in which four switch ICs are disposed at positions which are in line symmetry with respect to a single thermal fuse.
[FIG. 8(B)] Explanatory view showing an example in which four switch ICs are disposed at positions which are in rotational symmetry with respect to a single thermal fuse.
[FIG. 9(A)] Explanatory view showing an example in which four switch ICs are disposed at positions which are in line symmetry with respect to two thermal fuses.
[FIG. 9(B)] Explanatory view showing an example in which four switch ICs are disposed at positions which are in line symmetry with respect to two thermal fuses.
[FIGS. 10(A) and 10(B)] Plan and front views of a control apparatus which is another embodiment of the present invention.
[FIGS. 11(A) and 11(B)] Plan and front views of a control apparatus which is still another embodiment of the present invention.
[FIGS. 12(A) and 12(B)] Plan and front views of a control apparatus which is still another embodiment of the present invention.
[FIG. 13] Block diagram of a control apparatus which is still another embodiment of the present invention.

### [Modes for Carrying out the Invention]

### A. Overall Configuration of Control Apparatus

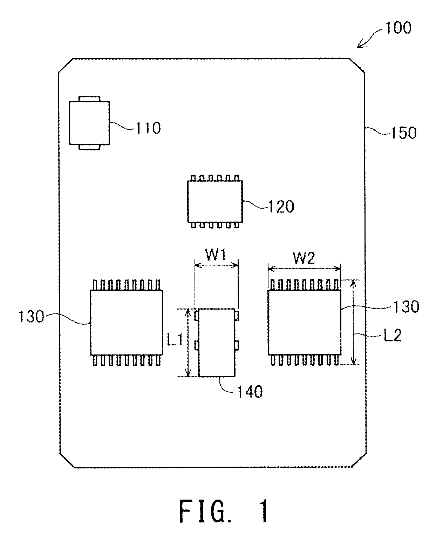

FIG. 1 is a plan view of a control apparatus 100 which is one embodiment of the present invention. This control apparatus 100 is configured as an apparatus for controlling a resistive load (e.g., a glow plug) for an automobile. This control apparatus 100 has a structure in which a power supply circuit 110, a controller IC 120, two switch ICs 130, and a thermal fuse 140 are disposed on a printed circuit board 150. The thermal fuse 140 is disposed at a position between the two switch ICs 130. Notably, although the control apparatus 100 includes electronic components other than the above-mentioned components, wiring traces, and various terminals, these are not shown in FIG. 1.

Each of the power supply circuit 110, the controller IC 120, and the switch ICs 130 is an electronic component constituted by an IC package. In the example of FIG. 1, the four types of components 110, 120, 130, and 140 are configured as surface-mount-type packages. Each of the switch ICs 130 is an IC package including a semiconductor switch. However, it is preferred that each of the switch ICs 130 be an IC package called IPD (Intelligent Power Device) which includes not only a semiconductor switch (e.g., an FET) but also a control circuit for the semiconductor switch (e.g., an FET gate drive circuit) and an overheat protection circuit.

In the example of FIG. 1, the dimension of the thermal fuse 140 in the longitudinal direction thereof is L1, and the dimension of the thermal fuse 140 in the lateral direction (width direction) thereof is W1. The dimension of each switch IC 130 in the longitudinal direction thereof is L2, and the dimension of each switch IC 130 in the lateral direction (width direction) thereof is W2. In general, L1 < L2 and W1 < W2. The longitudinal and lateral dimensions of each package are those of the contour of the entire package including both a mold portion and lead wires thereof.

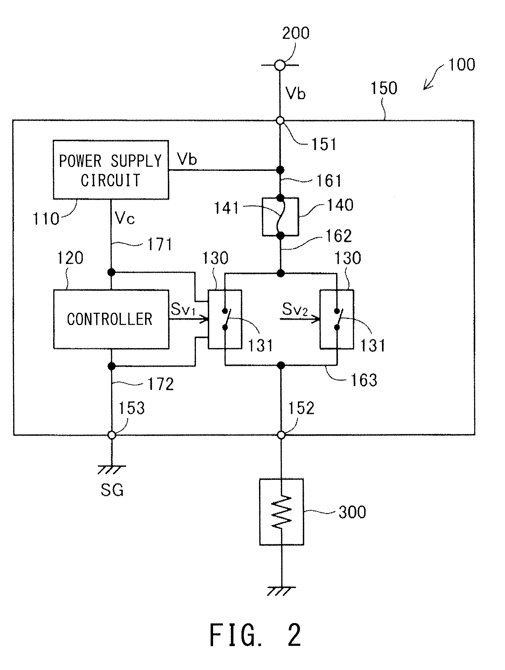

FIG. 2 is a block diagram showing the circuit configuration of the control apparatus 100 shown in FIG. 1. A power supply input terminal 151, a load connection terminal 152, and a signal ground terminal 153 are provided on the printed circuit board 150. A predetermined external power supply voltage Vb (DC voltage) is supplied to the power supply input terminal 151 from an external battery 200. This external power supply voltage Vb is supplied to the power supply circuit 110 and the thermal fuse 140 through a wiring trace 161 for external power supply.

The power supply circuit 110 produces, from the external power supply voltage Vb, a control power supply voltage Vc supplied to the controller IC 120 and control circuits (not shown) within the switch ICs 130. This control power supply voltage Vc is supplied to various control circuits disposed on the printed circuit board 150 through a wiring trace 171 for power supply. The various circuits, including the controller IC 120, are electrically connected to the signal ground terminal 153 of the printed circuit board 150 through a wiring trace 172 for signal ground. This wiring trace 172 is wiring for connecting the various circuits to a signal ground SG, and is also referred to as the "signal ground connection wiring 172." Neither a passive element nor an active element is present between the signal ground SG and the signal ground connection wiring 172. Therefore, the signal ground connection wiring 172 is a wiring line which is connected to the signal ground SG through only a wiring trace whose impedance is ignorable. The signal ground terminal 153 is connected to the signal ground SG provided on the printed circuit board 150 or outside the printed circuit board 150. Notably, in the case where the signal ground SG is realized by a wiring trace provided on the printed circuit board 150, the signal ground terminal 153 may be omitted. Also, the signal ground connection wiring 172 itself may be configured as a large wiring trace which functions as the signal ground SG.

The output terminal of the thermal fuse 140 is electrically connected to the current input terminals of the two switch ICs 130 through a first wiring trace 162 for current path. This wiring trace 162 corresponds to a current path trace on the high side (high voltage side) of the semiconductor switch 131 within each switch IC 130. The current output terminals of the two switch ICs 130 are electrically connected to the load connection terminal 152 of the printed circuit board 150 through a second wiring trace 163 for current path. This wiring trace 163 corresponds to a current path trace on the low side (low voltage side) of the semiconductor switch 131 within each switch IC 130. The load connection terminal 152 is connected to the input terminal of a resistive load 300 (e.g., a glow plug) of an automobile. The output terminal of the resistive load 300 is grounded. In this configuration, the semiconductor switches 131 of the switch ICs 130 are used to drive the resistive load 300 on the high side thereof. Notably, three or more switch ICs 130 may be provided in parallel.

The controller IC 120 turns on and off the two semiconductor switches 131 by supplying control signals Sv1 and Sv2 to the two switch ICs 130, to thereby energize and de-energize the resistive load 300. Notably, in the case where each switch IC 130 includes an FET gate drive circuit for driving the semiconductor switch 131, the control signals Sv1 and Sv2 supplied from the controller IC 120 may be signals each indicating a duty ratio used in PWM control.

The thermal fuse 140 is an overheat prevention component including a passive element 141 for preventing overheating of the switch IC 130. When the temperature of a switch IC 130 rises excessively due to a failure or a malfunction, the electrical connection within the thermal fuse 140 is broken as a result of the temperature rise, whereby current is interrupted. Heat is conducted from the switch ICs 130 to the thermal fuse 140 through mainly the wiring trace 162 between the switch ICs 130 and the thermal fuse 140. The passive element 141 of the thermal fuse 140 may be an element having a structure in which, when solder joining the electrical contacts of the passive element 141 melts as a result of a temperature rise, the electrical contacts are separated from each other through use of mechanical stress produced by a spring or the like. A coil spring or the like may be used as a spring which produces such mechanical stress. However, in FIG. 2, for convenience of depicting, the passive element 141 of the thermal fuse 140 is depicted as a simple fusible fuse. Notably, in the present embodiment, the resistive load 300 of the control apparatus 100 is a glow plug. Therefore, it is preferred to use, as the thermal fuse 140, a thermal fuse through which a large current for the glow plug can be caused to flow. Specifically, it is preferred that the thermal fuse 140 have an interrupting current (or a maximum rush current) of 200 A or greater. In this case, overheating of a plurality of switch ICs can be prevented through use of a single thermal fuse 140.

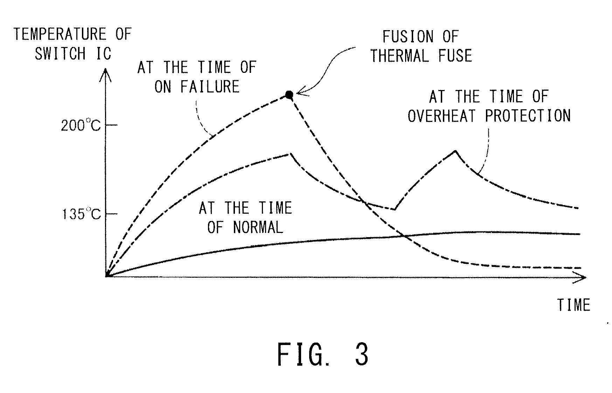

FIG. 3 is an explanatory graph showing an example of change in the temperature of a switch IC. In FIG. 3, the horizontal axis represents time, and the vertical axis represents the temperature of the switch IC. A solid line shows a temperature change at the time of normal operation. In the present embodiment, the control circuit within each switch IC 130 controls the corresponding semiconductor switch 131 by PWM control. At the time of normal operation, when a current flows through the resistive load 300 as a result of the PWM control, the temperature of the switch IC 130 rises gradually. However, the temperature of the switch IC 130 does not rise excessively. A chain line shows a temperature change in the case where, although the temperature of the switch IC 130 rises more quickly as compared with that at the time of normal operation due to a certain cause, the overheat protection circuit within the switch IC 130 operates to thereby prevent overheating of the switch IC 130. A dashed line shows a temperature change in the case where the semiconductor switch 131 of the switch IC 130 breaks and remains in the on state (ON failure). In this case, since the temperature of the switch IC 130 rises excessively, the thermal fuse 140 fuses and the current supplied to the switch IC 130 is interrupted.

In the above-described control apparatus 100, since the single thermal fuse 140 provides overheat protection for the plurality of switch ICs 130, the configuration of the entire control apparatus 100 can be simplified. In particular, as shown in FIG. 2, in the case where the thermal fuse 140 is in common connection with the high sides of the plurality of switch ICs 130, the following advantageous effect is attained. Namely, when the semiconductor switch 131 of one switch IC 130 breaks, there arises a possibility that an unintended current path is formed between the broken semiconductor switch 131 and the signal ground terminal 153 and an excessively large current flows therethrough. Even in such a case, if the thermal fuse 140 is in common connection with the high sides of the plurality of switch ICs 130, the current path through which such a large current flows to the plurality of switch ICs 130 can be cut off through fusion of the thermal fuse 140. As a result, the current flowing through the plurality of switch ICs 130 can be reliably interrupted by the thermal fuse 140.

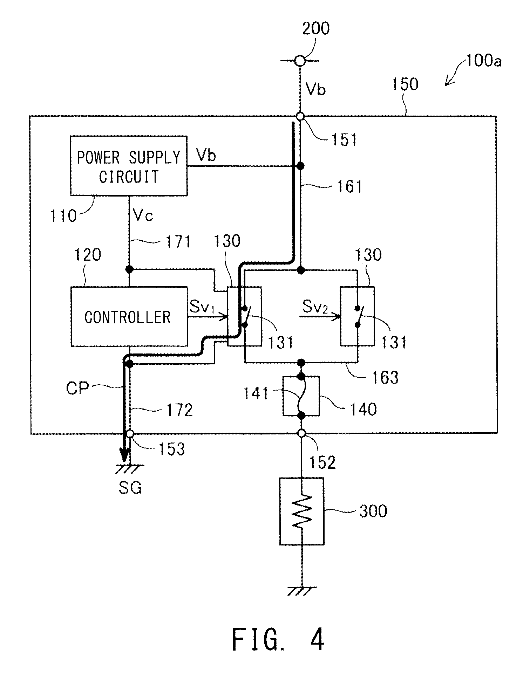

FIG. 4 is a block diagram showing the configuration of another control apparatus 100a in which a thermal fuse 140 is in common connection with the low sides of a plurality of switch ICs 130. The difference from the control apparatus 100 shown in FIG. 2 is the connecting position of the thermal fuse 140 only, and the remaining configuration is the same as the control apparatus 100 shown in FIG. 2. There is assumed a case where, in the control apparatus 100a of FIG. 4, the semiconductor switch 131 of one switch IC 130 breaks, and a current path CP extending from the high side of that semiconductor switch 131 to the signal ground terminal 153 is formed. In such case, even when the thermal fuse 140 fuses as a result of the temperature rise of the broken switch IC 130, the current path CP extending from the broken switch IC 130 to the signal ground terminal 153 can not be interrupted. Accordingly, in order to reliably cause the thermal fuse 140 to interrupt the current flowing through the broken switch IC 130 even when such a current path CP is formed, it is preferred that the thermal fuse 140 be commonly connected to the high sides of the plurality of switch ICs 130 as shown in FIG. 2. However, in the case where formation of such a current path CP does not cause a practical problem, the thermal fuse 140 may be commonly connected to the low sides of the plurality of switch ICs 130 as shown in FIG. 4.

As described above, in the above-described control apparatuses 100 and 100a, the single thermal fuse 140 provides overheat protection for the plurality of switch ICs 130. Therefore, the control apparatuses 100 and 100a have the advantages of simplifying the configuration of the entire control apparatus and preventing an excess increase in the area of the printed circuit board. In particular, in the case where the thermal fuse 140 is connected to the high sides of the plurality of switch ICs 130, the current flowing through the switch ICs 130 can be interrupted even when an unintended current path is formed between a broken switch IC 130 and the signal ground terminal 153.

### B. Preferred Positional Relation between Switch ICs and Thermal Fuse

In the case where a single thermal fuse 140 is used as a overheat prevention component common among a plurality of switch ICs 130 as shown in FIG. 1, the positional relation between the plurality of switch IC 130 and the thermal fuse 140 is important. Namely, in order to prevent overheating of the individual switch ICs 130 to the same degree, it is desired to dispose the individual switch ICs 130 in positions as close to the thermal fuse 140 as possible. For example, it is preferred that the shortest distance between the perimeter of each switch IC 130 and the perimeter of the thermal fuse 140 be smaller than the dimension L2 of the switch IC 130 in the longitudinal direction and the dimension W2 of the switch IC 130 in the width direction. More specifically, it is preferred that the shortest distance between the perimeter of each switch IC 130 and the perimeter of the thermal fuse 140 be equal to or less than 15 mm, more preferably, equal to or less than 10 mm. Also, it is preferred that the two switch ICs 130 be disposed in symmetry with respect to, for example, the thermal fuse 140. In the case where the individual switch ICs 130 are disposed at positions whose closeness to the thermal fuse 140 are approximately the same as described above, irrespective of which one of the switch ICs 130 breaks, overheating of the broken switch IC 130 can be prevented to the same degree through fusion of the thermal fuse 140. Notably, as will be described below, there can be employed various positional relations between the plurality of switch ICs 130 and the thermal fuse 140.

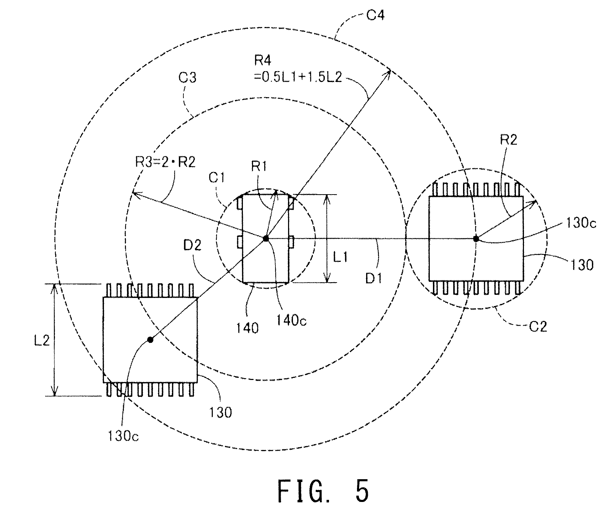

FIG. 5 is an explanatory view showing an example of a preferred layout condition of the switch ICs 130 and the thermal fuse 140. In this example, the following dimensions are employed.
(1) R1: the radius of a circumscribed circle C1 of the thermal fuse 140
(2) R2: the radius of a circumscribed circle C2 of each switch IC 130 (usually, R1 < R2)
(3) L1: the dimension of the thermal fuse 140 in the longitudinal direction
(4) L2: the dimension of each switch IC 130 in the longitudinal direction
(5) R3: the radius of a circle C3 depicted such that its radius becomes equal to (2-R2)
(6) R4: the radius of a circle C4 depicted such that its radius becomes equal to (0.5·L1 + 1.5·L2)
(7) D1, D2: the distance (inter-center distance) between the center 140c of the thermal fuse 140 and the center 130c of each switch IC 130

The circumscribed circle C1 of the thermal fuse 140 is a smallest circle which is circumscribed about the contour of the thermal fuse 140 including the mold portion and the lead wires thereof. The center 140c of the thermal fuse 140 is the center of the circumscribed circle C1. The circumscribed circle C2 and the center 130c of each switch IC 130 are also defined in the same manner. The circle C3 is a circle whose center coincides with the center 140c of the thermal fuse 140 and which has a radius (2·R2) twice the radius R2 of the circumscribed circle C2 of the switch IC 130. The circle C4 is a circle whose center coincides with the center 140c of the thermal fuse 140 and which has a radius (0.5·L1 + 1.5·L2) obtained by adding a value which is 1.5 times the dimension L2 of the switch IC 130 in the longitudinal direction to a value which is a half of the dimension L1 of the thermal fuse 140 in the longitudinal direction.

In FIG. 5, it is preferred that each switch IC 130 be disposed such that its center 130c is located within the circle C4 whose radius is (0.5-L1 + 1.5·L2). In this case, the distance between each switch IC 130 and the thermal fuse 140 becomes relatively short so that at the most one switch IC 130 is disposed therebetween. Therefore, overheating of each switch IC 130 can be prevented properly.

Also, it is preferred that each switch IC 130 be disposed such that its center 130c is located within the circle C3 whose radius is (2·R2). In this case, since the distance between each switch IC 130 and the thermal fuse 140 is limited to a shorter distance, overheating of each switch IC 130 can be prevented more reliably.

Notably, in the case where the center 130c of each switch IC 130 is located within the circle C4 or the circle C3 of FIG. 5, it is not required to equalize the inter-center distances D1 and D2 between the thermal fuse 140 and the switch ICs 130. However, it is preferred that each of the inter-center distances D1 and D2 are set to fall within a range of ±30% of the average of the inter-center distances D1 and D2. In this case, since variation in the distance between each switch IC 130 and the thermal fuse 140 can be reduced, irrespective of which one of the switch ICs 130 breaks, overheating of the broken switch IC 130 can be prevented to the same degree. This applies to the case where the number of switch ICs 130 is three or more. From the viewpoint of reducing variation in the distance between each switch IC 130 and the thermal fuse 140 and variation in the positional relation, it is preferred to dispose the centers 130c of the plurality of switch ICs 130 at positions which are spaced from the center 140c of the thermal fuse 140 by the same amount. In particular, it is further preferred to dispose the plurality of switch ICs 130 at respective positions which are in line symmetry or rotational symmetry with respect to the thermal fuse 140.

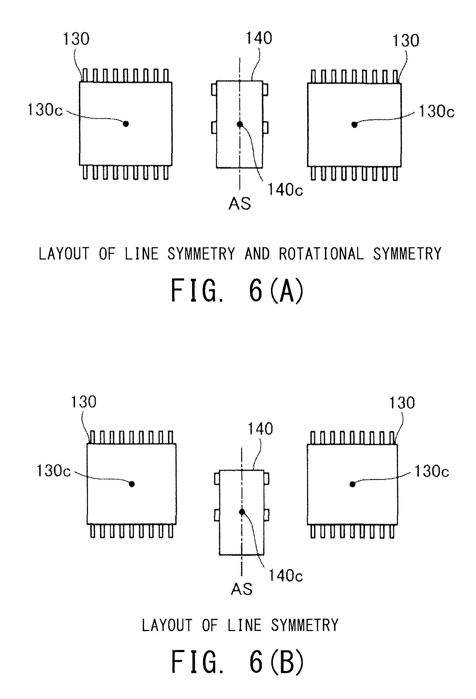

FIGS. 6(A) and 6(B) are explanatory views each showing an example in which two switch ICs 130 are disposed at positions which are in line symmetry/rotational symmetry with respect to a single thermal fuse 140. In the example of FIG. 6(A), the two switch ICs 130 are disposed at positions which are in line symmetry with respect to an axis of symmetry AS passing through the center 140c of the thermal fuse 140. Also, the two switch ICs 130 are disposed at positions which are in rotational symmetry with respect to the center 140c of the thermal fuse 140 and which are located at intervals of 180°. Notably, the entireties of the switch ICs 130 are not required to be in line symmetry and rotational symmetry, so long as at least the centers 130c of the switch ICs 130 are in line symmetry and rotational symmetry with respect to the center 140c of the thermal fuse 140. However, the example of FIG. 6(A) is further preferred, because the entireties of the switch ICs 130 are in line symmetry and rotational symmetry with respect to the center 140c of the thermal fuse 140. In the example of FIG. 6(B), the two switch ICs 130 are disposed at positions which are in line symmetry with respect to the axis of symmetry AS passing through the center 140c of the thermal fuse 140. However, in the example of FIG. 6(B), the two switch ICs 130 are not in rotational symmetry. Notably, the layout examples of FIGS. 6(A) and 6(B) are the same as the example shown in FIG. 1 in the point that the thermal fuse 140 is disposed at a position between the two switch ICs 130.

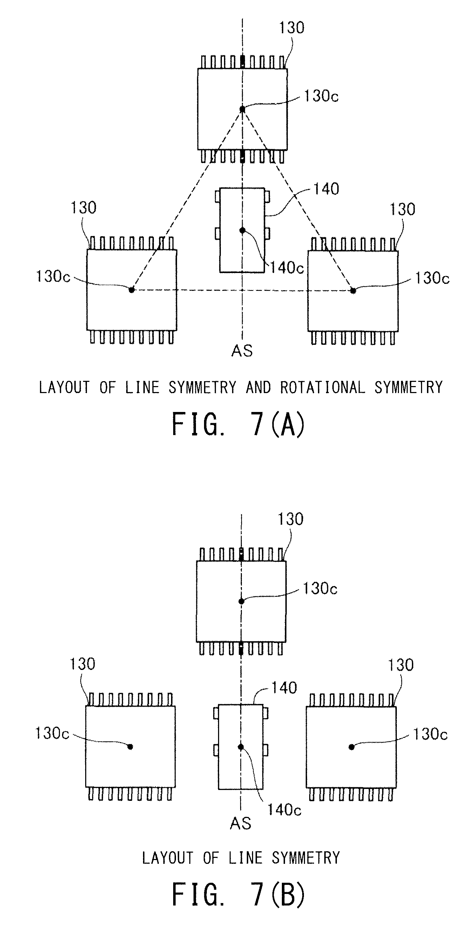

FIGS. 7(A) and 7(B) are explanatory views each showing an example in which three switch ICs 130 are disposed at positions which are in line symmetry/rotational symmetry with respect to a single thermal fuse 140. In the example of FIG. 7(A), the centers 130c of the three switch ICs 130 are disposed at positions which are in line symmetry with respect to an axis of symmetry AS passing through the center 140c of the thermal fuse 140. Also, the centers 130c of the three switch ICs 130 are disposed at positions which are in rotational symmetry with respect to the center 140c of the thermal fuse 140 and which are located at intervals of 120°. In the example of FIG. 7(B), although the three switch ICs 130 are disposed at positions which are in line symmetry with respect to the axis of symmetry AS passing through the center 140c of the thermal fuse 140, the three switch ICs 130 are not in rotational symmetry.

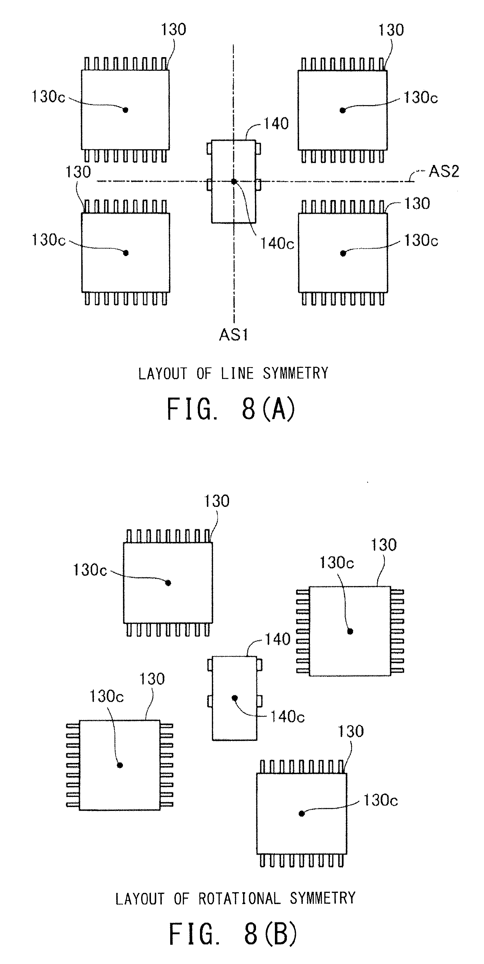

FIGS. 8(A) and 8(B) are explanatory views each showing an example in which four switch ICs 130 are disposed at positions which are in line symmetry or rotational symmetry with respect to a single thermal fuse 140. In the example of FIG. 8(A), the four switch ICs 130 are disposed at positions which are in line symmetry with respect to two axes of symmetry AS1 and AS2 passing through the center 140c of the thermal fuse 140 and being orthogonal to each other. In the example of FIG. 8(B), the centers 130c of the four switch ICs 130 are disposed at positions which are in rotational symmetry with respect to the center 140c of the thermal fuse 140 and which are located at intervals of 90°.

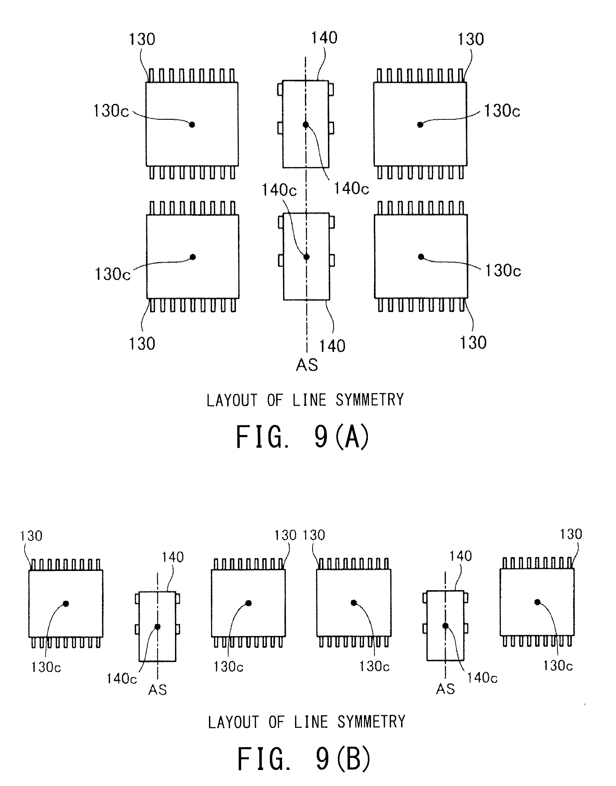

FIGS. 9(A) and 9(B) are explanatory views each showing an example in which four switch ICs 130 are disposed at positions which are in line symmetry with respect to two thermal fuses 140. In the example of FIG. 9(A), two thermal fuses 140 are disposed at the center, and two switch ICs 130 are disposed on the left and right sides of the thermal fuses 140. These four switch ICs 130 are disposed at positions which are in line symmetry with respect to an axis of symmetry AS passing through the centers 140c of the two thermal fuses 140. In the example of FIG. 9(B), a single thermal fuse 140 is disposed at the center of each pair of two switch ICs 130. Also, the two switch ICs 130 present on the opposite sides of the single thermal fuse 140 are disposed at positions which are in line symmetry with respect to an axis of symmetry AS passing through the center 140c of the thermal fuse 140. In FIGS. 9(A) and 9(B), each of the two thermal fuses 140 provides overheat protection for two switch ICs 130 located on the left and right sides thereof. In these cases, in the block diagram of FIG. 2, a circuit including two sets each of which is composed of a single thermal fuse 140 and two switch ICs 130 and which are connected in parallel is formed between the power supply input terminal 151 and the load connection terminal 152.

In the case where a plurality of switch ICs 130 are disposed at positions which are in line symmetry or rotational symmetry with respect to a thermal fuse 140 as shown in FIGS. 6(A) and 6(B) through FIGS. 9(A) and 9(B), the effect of preventing overheating of a broken or failed switch IC 130 to the same degree becomes particularly remarkable. Notably, even in the case where such a layout of line or rotational symmetry is employed, it is preferred to satisfy the positional relation between the switch ICs 130 and the thermal fuse 140 described with reference to FIGS. 1 and 5.

In consideration of the above-described various layouts, it is preferred that the layout of the switch ICs 130 and the thermal fuse(s) 140 satisfy one or more of the following conditions.

### <Layout condition 1>

Switch ICs 130 and a thermal fuse 140 which provides overheat protection for the switch ICs 130 have a positional relation such that no switch IC 130 is present between any of the switch ICs 130 and the thermal fuse 140 (FIG. 1 and FIG. 5 though FIGS. 9(A) and 9(B)).

### <Layout condition 2>

The shortest distance between the perimeter of each switch IC 130 and the perimeter of the thermal fuse 140 is smaller than the dimension L2 of each switch IC 130 in the longitudinal direction (FIG. 1).

### <Layout condition 3>

The shortest distance between the perimeter of each switch IC 130 and the perimeter of the thermal fuse 140 is smaller than the dimension W2 of each switch IC 130 in the lateral direction (FIG. 1).

### <Layout condition 4>

The center 130c of each switch IC 130 is disposed to be located within the circle C4 whose center coincides with the center 140c of the thermal fuse 140 and whose radius is (0.5·L1 + 1.5·L2) (FIG. 5). L1 is the dimension of the thermal fuse 140 in the longitudinal direction, and L2 is the dimension of each switch IC 130 in the longitudinal direction.

### <Layout condition 5>

The center 130c of each switch IC 130 is disposed to be located within the circle C3 whose center coincides with the center 140c of the thermal fuse 140 and whose radius is (2·R2) (FIG. 5). R2 is the radius of the circumscribed circle C2 of each switch IC 130.

### <Layout condition 6>

The plurality of switch ICs 130 and the thermal fuse 140 are disposed in such a manner that the inter-center distances D1, D2 ... between the plurality of switch ICs 130 and the thermal fuse 140 fall within the range of ±30% of the average of the inter-center distances (FIG. 5).

### <Layout condition 7>

The plurality of switch ICs 130 are disposed at positions which are in rotational symmetry or line symmetry with respect to the thermal fuse 140 (FIGS. 6(A) and 6(B) through FIGS. 9(A) and 9(B))

### <Layout condition 8>

The shortest distance between each switch IC 130 and the thermal fuse 140 is equal to or less than 15 mm, or is equal to or less than 10 mm.

Notably, these layout conditions 1 through 8 are conditions when the switch ICs 130 and the thermal fuse 140 are projected in the thickness direction of the printed circuit board 150.

In the case where, as described in the above-mentioned layout condition 1, the plurality of switch ICs 130 are disposed in such a manner that no switch IC 130 is present between any of the switch ICs 130 and the thermal fuse 140, irrespective of which one of the switch ICs 130 breaks, overheating of the broken switch IC 130 can be prevented to substantially the same degree by the thermal fuse 140. Further, when the plurality of switch ICs 130 are disposed to satisfy one or more of the above-mentioned various layout conditions 2 through 8, overheating of each broken switch IC 130 can be prevented more properly.

### C. Oher Embodiments

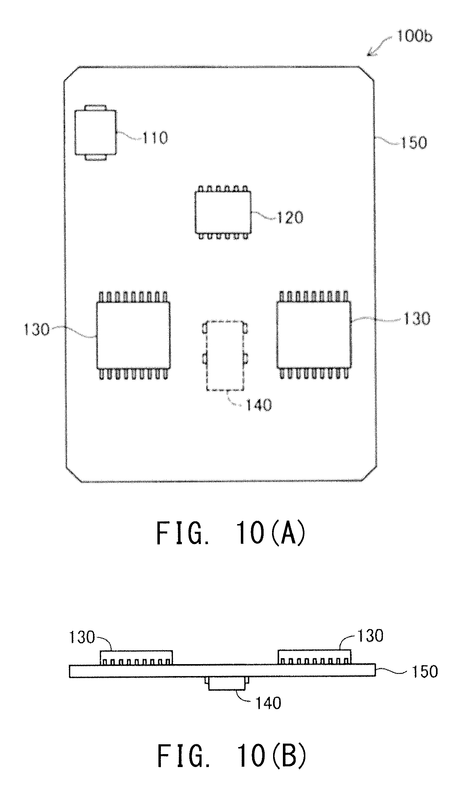

FIGS. 10(A) and 10(B) are plan and front views of a control apparatus 100b which is another embodiment of the present invention. The difference from the control apparatus 100 shown in FIG. 1 is only that, in the control apparatus 100b shown in FIGS. 10(A) and 10(B), a thermal fuse 140 is disposed on the back surface of a printed circuit board 150, and the remaining configuration is the same as the control apparatus 100 shown in FIG. 1. The control apparatus 100b shown in FIGS. 10(A) and 10(B) also yields effects substantially the same as those of the control apparatus 100 shown in FIG. 1. Also, since the switch ICs 130 and the thermal fuse 140 are disposed on different surfaces of the printed circuit board 150, the degree of freedom of layout increases, and the area of the printed circuit board 150 can be decreased.

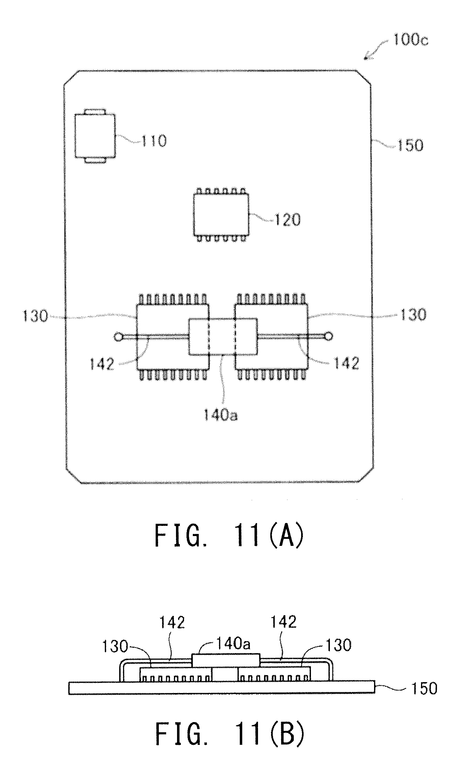

FIGS. 11(A) and 11(B) are plan and front views of a control apparatus 100c which is still another embodiment of the present invention. The difference from the control apparatus 100b shown in FIGS. 10(A) and 10(B) is only that, in the control apparatus 100c shown in FIGS. 11(A) and 11(B), two switch ICs 130 are disposed on a printed circuit board 150 such that they are located adjacent to each other, and that a thermal fuse 140a is disposed in a state in which it is in contract with the mold portions of the two switch ICs 130. The remaining configuration is the same as the control apparatus 100b shown in FIGS. 10(A) and 10(B). The lead wires 142 of the thermal fuse 140a are connected to pads of the printed circuit board 150 in a state in which the lead wires 142 extend over the switch ICs 130. This thermal fuse 140a is a so-called axial component. The control apparatus 100c shown in FIGS. 11(A) and 11(B) also yields effects substantially the same as those of the control apparatus 100 shown in FIG. 1 and the control apparatus 100b shown in FIGS. 10 (A) and 10 (B).

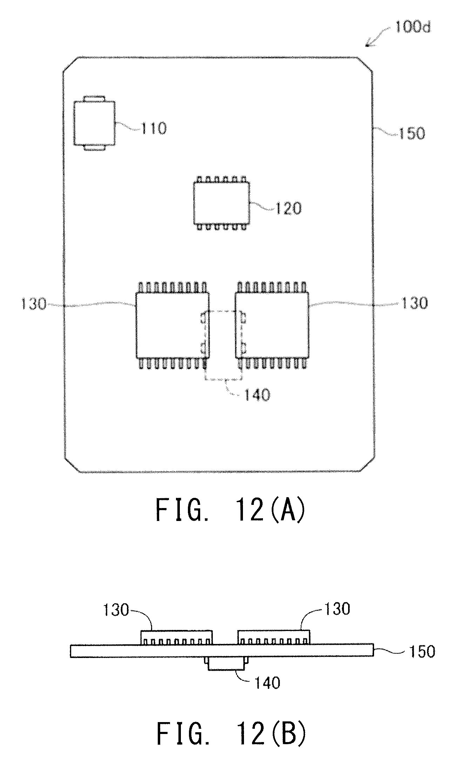

FIGS. 12(A) and 12(B) are plan and front views of a control apparatus 100d which is still another embodiment of the present invention. The difference from the control apparatus 100c shown in FIGS. 11(A) and 11(B) is only that, in the control apparatus 100d shown in FIGS. 12(A) and 12(B), a surface-mount-type thermal fuse 140 which is the same as that used in the control apparatus 100 shown in FIG. 1 is disposed on the back surface of a printed circuit board 150. The remaining configuration is the same as the control apparatus 100c shown in FIGS. 11(A) and 11(B).

In the embodiments shown in FIGS. 11(A) and 11(B) and FIGS. 12(A) and 12(B), when the plurality of switch ICs 130 and the thermal fuse 140a (or 140) are projected in the thickness direction of the printed circuit board 150, the plurality of switch ICs 130 and the thermal fuse 140a (or 140) are disposed such that the contour of the thermal fuse 140a (or 140) and the contour of each switch IC 130 partially overlap with each other. In this case, since the spatial distance between each switch IC 130 and the thermal fuse 140 decreases, overheating of each switch IC 130 can be prevented more effectively.

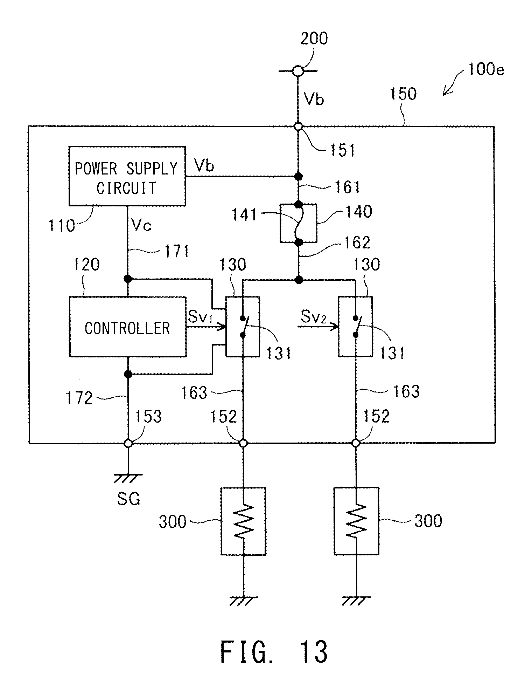

FIG. 13 is a block diagram showing the configuration of a control apparatus 100e which is still another embodiment of the present invention. The difference from the control apparatus 100 shown in FIG. 2 is only that, in the control apparatus 100e shown in FIG. 13, the output terminals of the individual switch ICs 130 are connected to different resistive loads 300 via different load connection terminals 152 provided on the printed circuit board 150, and the remaining structure is the same as the control apparatus 100 shown in FIG. 2. As described above, the individual switch ICs 130 may be used to drive the different resistive loads 300. In this case as well, since the thermal fuse 140 is in common connection with the plurality of switch ICs 130, the thermal fuse 140 can perform overheat protection for the plurality of switch ICs 130.

### D. Modifications

Notably, the present invention is not limited to the above-described examples and embodiments, and may be implemented in various forms without departing from the scope of the invention.

### First modification:

In the above-described embodiment, the thermal fuse 140 which includes a passive element having a function of interrupting current in response to temperature rise is used as an overheat prevention component. However, alternatively, there may be used an overheat prevention component which includes a passive element having a function of limiting current in response to temperature rise. For example, an overheat prevention component using a PTC thermistor can be used as the latter overheat prevention component. However, in the case where an overheat prevention component having a function of interrupting current is used, when an unintended current path CP as described with reference to FIG. 4 is formed, such a current path CP can be interrupted.

### [Description of Reference Numerals]

100, 100a to 100e: control apparatus
102: power supply input terminal
110: power supply circuit
120: controller IC
130: switch IC
131: semiconductor switch
140, 140a: thermal fuse
141: passive element
142: lead wire
150: printed circuit board
151: power supply input terminal
152: load connection terminal
153: signal ground terminal
161, 162, 163: wiring trace
171: wiring trace
172: signal ground connection wiring
200: battery
300: resistive load

## Claims

1. A control apparatus (100) in which a switch IC (130) is disposed on a printed circuit board (150), the switch IC (130) being an IC package including a semiconductor switch (131) and being provided on a high-voltage side of a resistive load (300) so as to drive the resistive load (300), wherein
a plurality of the switch ICs (130) are disposed on the printed circuit board (150);
an overheat prevention component (140) is provided and is in common connection with the plurality of switch ICs (130), the overheat prevention component (140) including a passive element (141) having a function of interrupting or limiting current flowing through the plurality of switch ICs (130) in response to temperature rise; and
the plurality of switch ICs (130) are disposed such that no switch IC (130) is present between any of the switch ICs (130) and the overheat prevention component (140).

2. A control apparatus (100) according to claim 1, wherein, when the plurality of switch ICs (130) and the overheat prevention component (140) are projected in a thickness direction of the printed circuit board (150), the plurality of switch ICs (130) are disposed such that the center (130c) of each switch IC (130) is present within a circle (C4) whose center coincides with the center (140c) of the overheat prevention component (140) and whose radius is (0.5-L1 + 1.5·L2), where L1 is the dimension of the overheat prevention component (140) in the longitudinal direction thereof, and L2 is the dimension of each switch IC (130) in the longitudinal direction thereof.

3. A control apparatus (100) according to claim 2, wherein, when the plurality of switch ICs (130) and the overheat prevention component (140) are projected in the thickness direction of the printed circuit board (150), the shortest distance between the perimeter of each switch IC (130) and the perimeter of the overheat prevention component (140) is smaller than the dimension (L2) of each switch IC (130) in the longitudinal direction thereof.

4. A control apparatus (100) according to any one of claims 1 to 3, wherein, when the plurality of switch ICs (130) and the overheat prevention component (140) are projected in the thickness direction of the printed circuit board (150), an inter-center distance which is the distance between the center (130c) of any of the switch ICs (130) and the center (140c) of the overheat prevention component (140) falls within a range of ±30% of the average of the inter-center distances regarding the plurality of switch ICs (130).

5. A control apparatus (100) according to any one of claims 1 to 4, wherein, when the plurality of switch ICs (130) and the overheat prevention component (140) are projected in the thickness direction of the printed circuit board (150), the centers (130c) of the plurality of switch ICs (130) are disposed at positions which are spaced from the center (140c) of the overheat prevention component (140) by the same amount.

6. A control apparatus (100) according to any one of claims 1 to 5, wherein, when the plurality of switch ICs (130) and the overheat prevention component (140) are projected in the thickness direction of the printed circuit board (150), the plurality of switch ICs (130) are disposed at positions which are in rotational symmetry or line symmetry with respect to the overheat prevention component (140).

7. A control apparatus (100) according to any one of claims 1 to 6, wherein
the plurality of switch ICs (130) and the overheat prevention component (140) are disposed on a first surface of the printed circuit board (150); and
the overheat prevention component (140) is disposed at a position between the plurality of switch ICs (130).

8. A control apparatus (100) according to any one of claims 1 to 6, wherein, when the plurality of switch ICs (130) and the overheat prevention component (140) are projected in the thickness direction of the printed circuit board (150), the plurality of switch ICs (130) and the overheat prevention component (140) are disposed in a positional relation such that the contour of the overheat prevention component (140) and the contour of each switch IC (130) partially overlap with each other.

9. A control apparatus (100) according to claim 8, wherein
the plurality of switch ICs (130) are disposed on a first surface of the printed circuit board (150); and
the overheat prevention component (140) is disposed on a second surface of the printed circuit board (150).

10. A control apparatus (100) according to any one of claims 1 to 9, wherein the passive element (141) is a thermal fuse having an interrupting current of 200 A or greater.

## Patentansprüche

1. Steuerungsvorrichtung (100), in der ein Schalt-IC (130) auf einer Leiterplatte (150) angeordnet ist, wobei der Schalt-IC (130) ein IC-Gehäuse ist, das einen Halbleiter-Schalter (131) enthält und sich an einer Hochspannungsseite einer ohmschen Last (300) befindet, um die ohmsche Last (300) anzusteuern,
wobei
eine Vielzahl der Schalt-ICs (130) auf der Leiterplatte (150) angeordnet sind;
eine Komponente (140) zur Verhinderung von Überhitzung vorhanden ist und in gemeinsamer Verbindung mit der Vielzahl von Schalt-ICs (130) steht, wobei die Komponente (140) zur Verhinderung von Überhitzung ein passives Element (141) enthält, dessen Funktion darin besteht, in Reaktion auf Temperaturanstieg Strom, der durch die Vielzahl von Schalt-ICs (130) fließt, zu unterbrechen oder zu begrenzen; und
die Vielzahl von Schalt-ICs (130) so angeordnet sind, dass kein Schalt-IC (130) zwischen beliebigen der Schalt-ICs (130) und der Komponente (140) zur Verhinderung von Überhitzung vorhanden ist.

2. Steuerungsvorrichtung (100) nach Anspruch 1, wobei, wenn die Vielzahl von Schalt-ICs (130) und die Komponente (140) zur Verhinderung von Überhitzung in einer Dickenrichtung der Leiterplatte (150) projiziert werden, die Vielzahl von Schalt-ICs (130) so angeordnet sind, dass der Mittelpunkt (130c) jedes Schalt-IC (130) im Inneren eines Kreises (C4) liegt, dessen Mittelpunkt mit dem Mittelpunkt (140c) der Komponente (140) zur Verhinderung von Überhitzung deckungsgleich ist und dessen Radius (0,5·L1 + 1,5·L2) beträgt, wobei L1 die Abmessung der Komponente (140) zur Verhinderung von Überhitzung in der Längsrichtung derselben ist und L2 die Abmessung jedes Schalt-IC (130) in der Längsrichtung desselben ist.

3. Steuerungsvorrichtung (100) nach Anspruch 2, wobei, wenn die Vielzahl von Schalt-ICs (130) und die Komponente (140) zur Verhinderung von Überhitzung in der Dickenrichtung der Leiterplatte (150) projiziert werden, der kürzeste Abstand zwischen dem äußeren Rand jedes Schalt-IC (130) und dem äußeren Rand der Komponente (140) zur Verhinderung von Überhitzung kürzer ist als die Abmessung (L2) jedes Schalt-IC (130) in der Längsrichtung desselben.

4. Steuerungsvorrichtung (100) nach einem der Ansprüche 1 bis 3, wobei, wenn die Vielzahl von Schalt-ICs (130) und die Komponente (140) zur Verhinderung von Überhitzung in der Dickenrichtung der Leiterplatte (150) projiziert werden, ein Mittelpunktabstand, der der Abstand zwischen dem Mittelpunkt (130c) eines beliebigen der Schalt-ICs (130) und dem Mittelpunkt (140c) der Komponente (140) zur Verhinderung von Überhitzung ist, in einem Bereich von ±30 % des Durchschnitts der Mittelpunktabstände bezüglich der Vielzahl von Schalt-ICs (130) liegt.

5. Steuerungsvorrichtung (100) nach einem der Ansprüche 1 bis 4, wobei, wenn die Vielzahl von Schalt-ICs (130) und die Komponente (140) zur Verhinderung von Überhitzung in der Dickenrichtung der Leiterplatte (150) projiziert werden, die Mittelpunkte (130c) der Vielzahl von Schalt-ICs (130) an Positionen angeordnet sind, die von dem Mittelpunkt (140c) der Komponente (140) zur Verhinderung von Überhitzung um das gleiche Maß beabstandet sind.

6. Steuerungsvorrichtung (100) nach einem der Ansprüche 1 bis 5, wobei, wenn die Vielzahl von Schalt-ICs (130) und die Komponente (140) zur Verhinderung von Überhitzung in der Dickenrichtung der Leiterplatte (150) projiziert werden, die Vielzahl von Schalt-ICs (130) an Positionen angeordnet sind, die in Rotationssymmetrie oder Achsensymmetrie zu der Komponente (140) zur Verhinderung von Überhitzung sind.

7. Steuerungsvorrichtung (100) nach einem der Ansprüche 1 bis 6, wobei
die Vielzahl von Schalt-ICs (130) und die Komponente (140) zur Verhinderung von Überhitzung auf einer ersten Fläche der Leiterplatte (150) angeordnet sind; und
die Komponente (140) zur Verhinderung von Überhitzung an einer Position zwischen der Vielzahl von Schalt-ICs (130) angeordnet ist.

8. Steuerungsvorrichtung (100) nach einem der Ansprüche 1 bis 6, wobei, wenn die Vielzahl von Schalt-ICs (130) und die Komponente (140) zur Verhinderung von Überhitzung in der Dickenrichtung der Leiterplatte (150) projiziert werden, die Vielzahl von Schalt-ICs (130) und die Komponente (140) zur Verhinderung von Überhitzung in einer Positionsbeziehung angeordnet sind, in der der Umriss der Komponente (140) zur Verhinderung von Überhitzung und der Umriss jedes Schalt-IC (130) einander teilweise überlappen.

9. Steuerungsvorrichtung (100) nach Anspruch 8, wobei
die Vielzahl von Schalt-ICs (130) auf einer ersten Fläche der Leiterplatte (150) angeordnet sind; und
die Komponente (140) zur Verhinderung von Überhitzung auf einer zweiten Fläche der Leiterplatte (150) angeordnet ist.

10. Steuerungsvorrichtung (100) nach einem der Ansprüche 1 bis 9, wobei das passive Element (140) eine Übertemperatursicherung ist, die einen Abschaltstrom von 200 A oder mehr hat.

## Revendications

1. Appareil de commande (100) dans lequel un circuit intégré de commutation (130) est disposé sur une carte à circuit imprimé (150), le circuit intégré de commutation (130) étant un boîtier de circuit intégré incluant un commutateur à semi-conducteur (131) et étant prévu du côté haute tension d'une charge résistive (300) de façon à attaquer la charge résistive (300), dans lequel
plusieurs circuits intégrés de commutation (130) sont disposés sur la carte à circuit imprimé (150),
un composant de prévention de surchauffe (140) est prévu et est relié en commun avec la pluralité de circuits intégrés de commutation (130), le composant de prévention de surchauffe (140) incluant un élément passif (141) présentant la fonction d'interrompre ou de limiter le courant circulant au travers de la pluralité de circuits intégrés de commutation (130) en réponse à une élévation de température, et
la pluralité de circuits intégrés de commutation (130) est disposée de telle sorte qu'aucun circuit intégré de commutation (130) n'est présent entre l'un quelconque des circuits intégrés de commutation (130) et le composant de prévention de surchauffe (140).

2. Appareil de commande (100) selon la revendication 1, dans lequel, lorsque la pluralité de circuits intégrés de commutation (130) et le composant de prévention de surchauffe (140) sont projetés dans la direction de l'épaisseur de la carte à circuit imprimé (150), la pluralité de circuits intégrés de commutation (130) est disposée de sorte à ce que le centre (130c) de chaque circuit intégré de commutation (130) soit présent à l'intérieur d'un cercle (C4) dont le centre coïncide avec le centre (140c) du composant de prévention de surchauffe (140) et dont le rayon vaut : (0,5 · L1 + 1,5 · L2), où L1 représente la dimension du composant de prévention de surchauffe (140) dans la direction longitudinale de celui-ci, et où L2 représente la dimension de chaque circuit intégré de commutation (130) dans la direction longitudinale de celui-ci.

3. Appareil de commande (100) selon la revendication 2, dans lequel, lorsque la pluralité de circuits intégrés de commutation (130) et le composant de prévention de surchauffe (140) sont projetés dans la direction de l'épaisseur de la carte à circuit imprimé (150), la distance la plus courte entre le périmètre de chaque circuit intégré de commutation (130) et le périmètre du composant de prévention de surchauffe (140) est plus petite que la dimension (L2) de chaque circuit intégré de commutation (130) dans la direction longitudinale de celui-ci.

4. Appareil de commande (100) selon l'une quelconque des revendications 1 à 3, dans lequel, lorsque la pluralité de circuits intégrés de commutation (130) et le composant de prévention de surchauffe (140) sont projetés dans la direction de l'épaisseur de la carte à circuit imprimé (150), la distance entre centres, qui représente la distance entre le centre (130c) de l'un quelconque des circuits intégrés de commutation (130) et le centre (140c) du composant de prévention de surchauffe (140), se retrouve dans une plage de ±30 % de la moyenne des distances entre centres par rapport à la pluralité de circuits intégrés de commutation (130).

5. Appareil de commande (100) selon l'une quelconque des revendications 1 à 4, dans lequel, lorsque la pluralité de circuits intégrés de commutation (130) et le composant de prévention de surchauffe (140) sont projetés dans la direction de l'épaisseur de la carte à circuit imprimé (150), les centres (130c) de la pluralité de circuits intégrés de commutation (130) sont disposés à des positions qui sont espacées de la même distance du centre (140c) du composant de prévention de surchauffe (140).

6. Appareil de commande (100) selon l'une quelconque des revendications 1 à 5, dans lequel, lorsque la pluralité de circuits intégrés de commutation (130) et le composant de prévention de surchauffe (140) sont projetés dans la direction de l'épaisseur de la carte à circuit imprimé (150), la pluralité de circuits intégrés de commutation (130) est disposée à des positions qui sont placées en symétrie de rotation ou en symétrie linéaire par rapport au composant de prévention de surchauffe (140).

7. Appareil de commande (100) selon l'une quelconque des revendications 1 à 6, dans lequel
la pluralité de circuits intégrés de commutation (130) et le composant de prévention de surchauffe (140) sont disposés sur une première surface de la carte à circuit imprimé (150), et
le composant de prévention de surchauffe (140) est disposé à une position qui est située entre la pluralité de circuits intégrés de commutation (130).

8. Appareil de commande (100) selon l'une quelconque des revendications 1 à 6, dans lequel, lorsque la pluralité de circuits intégrés de commutation (130) et le composant de prévention de surchauffe (140) sont projetés dans la direction de l'épaisseur de la carte à circuit imprimé (150), la pluralité de circuits intégrés de commutation (130) et le composant de prévention de surchauffe (140) sont disposés selon une relation de position telle que le contour du composant de prévention de surchauffe (140) et le contour de chaque circuit intégré de commutation (130) se chevauchent partiellement l'un avec l'autre.

9. Appareil de commande (100) selon la revendication 8, dans lequel
la pluralité de circuits intégrés de commutation (130) est disposée sur une première surface de la carte à circuit imprimé (150), et
le composant de prévention de surchauffe (140) est disposé sur une seconde surface de la carte à circuit imprimé (150).

10. Appareil de commande (100) selon l'une quelconque des revendications 1 à 9, dans lequel l'élément passif (141) est un fusible thermique présentant un courant de coupure de 200 A ou plus.
